Europäisches Patentamt

European Patent Office

Office européen des brevets

(11) Numéro de publication: **0 619 611 A1**

(12) **DEMANDE DE BREVET EUROPEEN**

(21) Numéro de dépôt: **94200880.6**

(22) Date de dépôt: **30.03.94**

(51) Int. Cl.5: **H01L 29/08**

(30) Priorité: **07.04.93 FR 9304137**

(43) Date de publication de la demande:
**12.10.94 Bulletin 94/41**

(84) Etats contractants désignés:
**DE FR GB IT NL**

(71) Demandeur: **PHILIPS COMPOSANTS**
**4, rue du Port aux Vins**
**F-92150 Suresnes (FR)**
(84) **FR**

(71) Demandeur: **N.V. Philips'**
**Gloeilampenfabrieken**
**Groenewoudseweg 1**
**NL-5621 BA Eindhoven (NL)**
(84) **DE GB IT NL**

(72) Inventeur: **Leduc, Pierre**
**Société Civile S.P.I.D.,**
**156, Boulevard Haussmann**
**F-75008 Paris (FR)**

(74) Mandataire: **Lottin, Claudine et al**
**Société Civile S.P.I.D.**
**156, Boulevard Haussmann**
**F-75008 Paris (FR)**

(54) **Dispositif semiconducteur comprenant un transistor vertical.**

(57) Dispositif semiconducteur comprenant un transistor vertical, par exemple du type PNP ayant un substrat (1) P réalisant le collecteur, avec à sa surface une couche épitaxiale (3) N dans laquelle est formée une région d'émetteur (15,16) P, la partie (9) de couche épitaxiale (3) entre émetteur (15,16) et collecteur (1) réalisant la base.

Dans ce transistor vertical, le gain en courant est très fortement augmenté, lorsque l'émetteur est formé d'unedite première région partielle d'émetteur faiblement dopée P, s'étendant sous une couche isolante (6) et d'unedite seconde région partielle d'émetteur (16) fortement dopée P++ s'étendant sous la zone de contact d'émetteur (26) délimitée par une ouverture dans la couche isolante (6). Les épaisseurs et les dopages respectifs des première (15) et seconde (16) régions d'émetteur sont prévus pour que la première région soit transparente aux électrons et la seconde forme un écran pour les électrons. De plus, le rapport des aires des deux régions partielles (Sox/Sm) est supérieur à 2, l'aire (Sm) de la seconde région (16) étant choisie petite. Les diverses régions du transistor sont formées de couches très minces. Le transistor peut aussi être NPN.

FIG.1B

Rank Xerox (UK) Business Services
(3.10/3.09/3.3.4)

L'invention concerne un dispositif semiconducteur comprenant un transistor vertical, lequel présente :

- une région de collecteur et une région d'émetteur, chacune d'un premier type de conductivité, la région d'émetteur affleurant à une surface principale du dispositif semiconducteur ;
- une région intermédiaire de base d'un second type de conductivité ;
- au moins unedite zone de contact électrique d'émetteur pour un plot métallique de contact électrique d'émetteur, délimitée par une ouverture pratiquée en surface de la région d'émetteur dans une couche isolante disposée sur ladite surface principale,

et transistor dans lequel le rapport entre l'aire de la région d'émetteur sous la couche isolante, dite première région partielle d'émetteur, et l'aire de la région d'émetteur sous ladite zone de contact électrique d'émetteur, dite seconde région partielle d'émetteur, est au moins égal à 2.

L'invention trouve son application dans tout circuit intégré comprenant des transistors bipolaires verticaux dans lesquels on recherche un gain en courant amélioré.

Dans l'exposé qui suit, par porteurs minoritaires, il faut entendre les électrons lorsque la région considérée est de type P, et il faut entendre les trous lorsque la région considérée est de type N.

Un dispositif semiconducteur comprenant un transistor vertical à gain élevé muni des caractéristiques citées plus haut est déjà connu d'un premier document de l'état de la technique constitué par le brevet EP 0 401 354.

Ce brevet concerne un transistor bipolaire vertical ayant une région de collecteur, et au moins une région d'émetteur, par exemple de type P, affleurant à la surface principale d'un circuit, et une région intermédiaire, dans ce cas de type N. Ce transistor comporte à sa surface une couche isolante dans laquelle est formée au moins une ouverture délimitant la zone effective de contact électrique entre la région d'émetteur et le plot métallique de contact électrique d'émetteur. Ce transistor a pour caractéristique que la région d'émetteur présente une épaisseur constante et un niveau de dopage homogène tels que la longueur de diffusion des porteurs minoritaires injectés verticalement dans toute cette région est supérieure ou égale à l'épaisseur de cette région d'émetteur. En outre le rapport entre l'aire de la région d'émetteur et l'aire de la zone effective du contact électrique d'émetteur est choisi supérieur ou égal à 5, et de préférence compris entre 20 et 300.

Dans ces conditions le dispositif connu présente un gain en courant $\beta$ élevé tel que :

$\beta$ = 150 si le rapport des aires est de 5 à 7,

$\beta$ = 1620 mesuré, et 1765 calculé, si le rapport est 146.

Ce gain en courant tend vers une valeur asymptotique qui est à peu près atteinte quand le rapport est égal à 300. D'où les valeurs 20 à 300 citées comme préférées pour ce rapport.

Dans la réalisation de ce dispositif connu la zone effective de contact d'émetteur avait une aire de l'ordre de 16 $\mu$m$^2$, ce qui conduisait, lorsque le rapport des aires était égal à 146, à une aire de région d'émetteur de 2350 $\mu$m$^2$. Une telle aire d'émetteur résultait dans le fait que le transistor vertical connu ne pouvait pas être inclus dans les circuits intégrés à taux d'intégration élevé (LSI, ou VLSI en anglais).

Le dopage de la couche d'émetteur était de l'ordre de $2.10^{16}$ atomes.cm$^{-1}$ et l'épaisseur de la région d'émetteur était de l'ordre de 0,8 $\mu$m.

Le procédé de réalisation du transistor vertical divulgué par ce brevet EP 0401354 comprenait la formation d'un substrat en silicium de type P, d'une couche épitaxiale de type N et d'un caisson d'isolement en SiO$_2$ pour délimiter le transistor. Au centre du caisson, on implantait dans la couche épitaxiale N, une région d'émetteur de type P et d'épaisseur 0,6 à 0,8 $\mu$m, laissant subsister un intervalle de type N pour former la base entre la région d'émetteur implantée P, et le substrat P formant le collecteur du transistor vertical. Des ouvertures étaient ménagées dans une couche isolante et protectrice supérieure en SiO$_2$, pour permettre la réalisation des divers plots métalliques de contact.

Un autre transistor bipolaire vertical, également à gain élevé, est par ailleurs connu d'un second document de l'état de la technique constitué par le brevet US-4 007 474 du 8 février 1977. Ce second document décrit un dispositif semiconducteur avec des moyens pour augmenter le gain en courant d'un transistor bipolaire vertical NPN. La région d'émetteur de ce transistor est composée de deux régions partielles : une première région partielle de faible conductivité N$^-$ qui présente une aire et une profondeur plus grande qu'une deuxième région partielle de forte conductivité N$^+$.

Ainsi, l'épaisseur de la deuxième région partielle N$^+$, laquelle affleure à la surface du dispositif immédiatement sous la zone de contact électrique du plot d'émetteur, est de 1 $\mu$m ; et son taux de dopage au phosphore, dans le silicium, de $10^{20}$ cm$^{-3}$.

L'épaisseur de la première région partielle N$^-$, considérée entre la deuxième région partielle N$^+$ et la couche de base, est de 2 à 5 $\mu$m ; et son taux de dopage avec l'antimoine dans le silicium est approximativement $5,5.10^{15}$ cm$^{-3}$.

Le procédé de réalisation du transistor vertical connu de ce second document cité comprend la formation d'un substrat de type N fortement dopé pour former le collecteur, sur lequel est réalisée une couche épitaxiale également de type N, utilisée comme collecteur en conjonction avec le substrat, cette couche épitaxiale ayant une épaisseur de 20 $\mu$m.

La couche de base d'épaisseur 3 $\mu$m est réalisée par diffusion de type P dans cette couche épitaxiale. Puis les régions d'émetteurs N sont formées en surface avec les conductivités et épaisseurs déjà citées.

C'est-à-dire que, d'une manière générale, le transistor connu de ce second document cité était réalisé dans une technologie encore en usage dans la période de temps autour de 1980, et qui consistait à employer des couches de l'ordre de 20 $\mu$m pour réaliser les transistors. De plus, dans cette technologie, la zone de contact d'émetteur était à peu près d'aire égale à l'aire de la région d'émetteur elle-même, et cette aire était de préférence aussi grande que possible pour minimiser la résistance.

L'épaisseur totale de la première et de la seconde régions partielles d'émetteur, considérée verticalement, est dite inférieure à la longueur de diffusion dans la région partielle faiblement dopée, et l'épaisseur de la région très dopée est très inférieure à l'épaisseur de la région faiblement dopée.

Dans ce dispositif connu, la région faiblement dopée est réalisée au moyen d'une couche épitaxiale N⁻ formée en surface d'une couche épitaxiale dopée P constituant la base, le tout en surface du collecteur. La région fortement dopée est alors réalisée par diffusion N⁺ dans la couche épitaxiale N⁻ de manière telle qu'elle forme une couche très superficielle couvrant sensiblement toute la surface de la couche faiblement dopée N⁻ sous-jacente. De cette manière les deux régions d'émetteur forment un empilement ayant une jonction horizontale. Il est enseigné qu'il est important que cette jonction horizontale entre ces deux régions à fort et faible dopage, notée L-H, soit à au moins 4 $\mu$m de la jonction émetteur-base, dans la direction verticale.

La structure de l'émetteur qui est du type LEC (Low Emitter Concentration, en anglais) est par ailleurs de forme et dimension spécifiques.

Les transistors verticaux sont importants pour la réalisation de circuits intégrés dans lesquels le concepteur désire insérer des transis tors inverseurs avec des transistors sources de courant. Dans ce cas, le plus souvent, les transistors inverseurs sont réalisés par des transistors latéraux, et les transistors source de courant par des transistors verticaux.

Les gains en courant des transistors verticaux sont plus élevés (50 à 100) que ceux des transistors latéraux (< 50). Le premier document cité au titre d'état de la technique enseigne que le transistor vertical proposé permet d'atteindre un gain en courant de l'ordre de 150 à 1800, selon les rapports de surface en jeu. Le second document cité au titre d'état de la technique fait état carrément d'un gain en courant de l'ordre de 10000 ($10^4$).

De nombreuses expérimentations ont été menées dans le but de mettre en oeuvre ledit transistor vertical proposé par le second document cité, afin d'obtenir le gain très avantageux qui paraissait pouvoir être obtenu. Certes, ce transistor connu s'est révélé bas bruit comme décrit dans le document cité.

Cependant, il faut prendre en compte que, non seulement l'émetteur est faiblement dopé ($5,5.10^5$ cm⁻³), mais que également la base est faiblement dopée ($10^{16}$ cm⁻³). C'est là le phénomène le plus important de ce second brevet cité. En effet, l'expérimentation a montré que, même si on ne réalise pas la région partielle d'émetteur fortement dopée N⁺⁺, dans ce dispositif connu, on obtient néanmoins le gain annoncé de 10 000 ($10^4$). Ceci est dû à une erreur dans la théorie physique énoncée dans le brevet. Le fort gain n'est donc pas dû à la couche fortement dopée, mais au fait qu'à la fois la couche de base et la couche principale d'émetteur sont faiblement dopées. L'efficacité d'injection est alors augmentée. En réalité, la théorie générale des transistors s'applique à la structure du transistor décrite dans ce second document cité, et non pas la théorie énoncée dans ledit document.

L'augmentation du gain est donc due à un artifice (le faible dopage de la base) qui n'est pas mis en lumière, mais qui produit un désavantage rédhibitoire : Le gain annoncé est réellement obtenu seulement lorsque, à la fois, la base et l'émetteur sont peu dopés, que la région partielle d'émetteur très dopée existe ou non. Cette région fortement dopée ne participe pas aux résultats concernant le gain annoncé, car l'efficacité d'injection n'est pas due aux effets de surface mais à l'intégrale des impuretés efficaces dans l'émetteur.

La conséquence est que, dans la plupart des cas, ce transistor connu du second document cité ne peut pas être utilisé, car il présente, du fait du faible dopage des régions de base et d'émetteur, une tension de claquage beaucoup trop faible. A l'appui de ces conclusions, on lira avec profit la publication de H.G. de GRAAFF et J.W. SLOTBOON, dans "Solid State Electronics" N° 19, p. 809, 1976, qui décrit les différents aspects du comportement des transistors à émetteurs faiblement dopés (LEC). D'une manière générale, dans le domaine des transistors, l'homme du métier doit se montrer très prudent, lorsque des résultats très prometteurs sont annoncés, afin de s'assurer que ces résultats sont réellement obtenus par les moyens décrits, et sans contrepartie néfaste.

En ce qui concerne par ailleurs le transistor à fort gain connu du premier document cité au titre d'état de la technique, ce dispositif a le désavantage d'être très encombrant. Or, dans l'état actuel de la technologie, il est principalement recherché d'augmenter considérablement la densité d'intégration des éléments actifs et passifs sur un même substrat. Cette condition est un impératif absolu de l'industrie des semiconducteurs.

Alors que le dispositif connu du premier document cité a des performances de gain attractives, en revanche ses dimensions le font écarter du développement industriel des circuits à très haute densité d'intégration.

Néanmoins, ce dispositif connu de ce premier état de la technique (datant de 1988) marque un tournant dans la technologie des transistors bipolaires verticaux, car son fonctionnement repose sur des effets de surface totalement inconnus de l'état de la technique en vigueur jusque là, et correspond à des théories totalement nouvelles et en complet désaccord avec les théories sur lesquelles reposait l'état de la technique précédemment en usage et décrites dans le second document cité (datant de 1977).

Pour comprendre la nouvelle théorie appliquée dans ce brevet EP 0401 354 (premier document cité), l'homme du métier lira avec profit la publication intitulée "The Physics and Modeling of Heavily Doped Emitters" par Jesus A. del ALAMO et Richard M. SWANSON dans IEEE Transactions on Electron Devices, Vol.ED-31, N°12, December 1984, pp. 1878-1888. Par émetteurs fortement dopés, il faut entendre, à l'époque de la publication, des émetteurs plus dopés que les transistors dits LEC, c'est-à-dire dopés à environ $10^{18}$ à $10^{20}$ cm$^{-3}$ pour des transistors à couche d'émetteur épaisse entre 2 et 10 $\mu$m. De cette publication, il ressort que le fonctionnement des émetteurs fortement dopés des transistors à couches épaisses est gouverné par le transport et la recombinaison des porteurs minoritaires, mais que les mécanismes affectant le temps de vie des porteurs minoritaires dans le silicium sont extrêmement complexes et doivent faire l'objet de recherches extensives. Cette publication indique encore que, dans de nombreux cas, les résultats expérimentaux sont en contradiction avec les résultats de modélisation. Ceci provient du fait qu'à cause de la complexité des phénomènes en jeu, la modélisation ne peut prendre en compte tous les paramètres. Seules des recherches poussées peuvent venir à bout du problème relatif au comportement et au temps de recombinaison des porteurs minoritaires dans le silicium, dans les émetteurs des transistors.

Cependant, cette publication établit que ce comportement dépend du dopage et de l'épaisseur de la couche d'émetteur. Et le dispositif décrit dans la demande EP-0 401 354 (premier document cité) réalise une sélection de moyens mettant en oeuvre cet enseignement de la publication IEEE citée pour fournir la structure de transistor bipolaire vertical ayant un gain amélioré déjà décrit. Ainsi, avec l'apparition de la nouvelle théorie mise en application dans ce brevet EP 0 401 354 présentant un émetteur d'aire entre 20 et 300 fois plus étendue qu'il n'était d'usage dans les dispositifs conventionnels, et une zone de contact d'aire extrêmement petite, l'homme du métier se voyait dans l'obligation de reconsidérer sérieusement tout ce qui faisait le fondement de ses connnaissances générales antérieures, avec toutes les difficultés annoncées dans la publication IEEE.

C'est pourquoi, il apparaissait jusqu'à ce jour particulièrement difficile d'améliorer le dispositif décrit dans le brevet EP 0 401 354 (premier document cité) ; alors même qu'il était impératif pour son utilisation industrielle dans les circuits LSI (Large Scale Integration en anglais) à grande densité d'intégration, ou VLSI (Very Large Scale Integration) à très grande densité d'intégration, de réduire considérablement ses dimensions, tout en préservant la qualité très précieuse de gain hautement amélioré.

Or il se trouve que loin d'apporter une aide à l'homme du métier, des nouvelles conditions imposées par l'évolution des technologies, ont au contraire renforcé la difficulté de résoudre ce problème. Ces nouvelles conditions sont issues d'un tournant technologique récent qui consiste à réaliser les couches, épitaxiales et implantées, avec des épaisseurs environ 2 à 10 fois plus faibles que ce qui était le cas dans la demande de brevet EP 0 401 354 précitée, conduisant à des épaisseurs de couche épitaxiale de l'ordre de 1 $\mu$m, couche dans laquelle sont formées les régions d'émetteur et de base avec des épaisseurs également faibles. Du fait de cette évolution, il est apparu que le gain des transistors verticaux diminuait corrélativement à la réduction d'épaisseur des couches utilisées. Ainsi, de nouveau, les connaissances générales de l'homme du métier étaient remises en cause, et son expérience acquise dans la compréhension des phénomènes liés aux émetteurs des transistors devait être reconsidérée sur ces bases nouvelles, du fait que les anciennes théories liées aux transistors à couches épaisses n'étaient plus directement applicables.

Le dispositif connu du second document cité (US 4 007 474) est considéré comme non conforme aux normes technologiques et aux exigences de performances actuelles, et surtout comme ne pouvant pas être modifié, adapté ou perfectionné pour atteindre ces caractéristiques actuellement nécessaires.

Le problème technique se pose donc maintenant de manière urgente, de réaliser un dispositif à transistor vertical, compatible avec les nouvelles technologies à couches très minces, de faible surface compatible avec l'intégration à grande échelle et/ou présentant un gain en courant amélioré par rapport au premier état de la technique cité, alors que ces conditions regroupées semblent particulièrement contradictoires, et sans détérioration de ses autres propriétés.

Ce problème technique est résolu au moyen du dispositif défini dans le préambule et en outre caractérisé en ce que :

- les régions d'émetteur et de base sont du type dit mince ou ultramince,
- la première région partielle d'émetteur a unedite première épaisseur (h1) et undit premier niveau du premier type de conductivité obtenu par un premier taux de dopage, tels que la longueur de diffusion des porteurs minoritaires injectés verticalement dans cette première région partielle est supérieure ou égale à son épaisseur,
- la seconde région partielle d'émetteur a une seconde épaisseur h2 de valeur au moins moitié de ladite première épaisseur h1, et undit second niveau du premier type de conductivité plus élevé que le premier, ce second niveau étant obtenu par un second taux de dopage plus élevé que le premier taux de dopage, cette seconde épaisseur et ce second taux étant choisis tels que cette seconde région partielle constitue un écran pour les porteurs minoritaires.

Avec ce dispositif semiconducteur, on obtient l'avantage que le gain en courant du transistor vertical est nettement plus élevé, à dimensions égales, que celui du transistor connu du premier document cité, ou bien est aussi élevé avec des dimensions inférieures, et ceci avec une technologie de couches minces conforme aux nouveaux objectifs.

Le dispositif selon l'invention peut donc présenter de meilleures performances en terme de gain en courant et/ou être plus facilement intégrable à grande et très grande échelle (LSI, VLSI) avec un gain aussi grand.

L'effet produit par les nouveaux moyens techniques appliqués à l'émetteur du transistor est d'autant plus efficace que les couches formant le transistor sont minces. Non seulement cet effet permet de compenser complètement l'effet néfaste produit sur le gain par l'utilisation de technologie à couches minces, mais encore le gain est d'autant mieux amélioré que les couches sont plus minces.

L'invention est décrite ci-après en détail, en référence avec les figures schématiques annexées, dont :

- la FIG. 1A montre, vue du dessus, une partie d'un dispositif semiconducteur comprenant un transistor bipolaire vertical ;
- la FIG.1B est une vue en coupe selon l'axe B-B du transistor bipolaire vertical de la FIG.1A ;
- la FIG.2 est une représentation symbolique, appliquée à une coupe schématique d'une région d'émetteur d'un transistor bipolaire vertical, des participations des densités de courant dans les différentes parties de la région d'émetteur ;
- la FIG.3 montre des courbes comparatives du gain en courant $H_{FE}$, en fonction du rapport des aires d'émetteur sous la couche isolante Sox et d'émetteur sous la zone de contact électrique Sm ;
- les FIG.4A et 4B montrent des courbes représentatives des taux de dopage en fonction de la profondeur, à partir de la surface de la région d'émetteur, sous la couche isolante pour la FIG.4A, et sous la zone de contact électrique pour la FIG.4B.

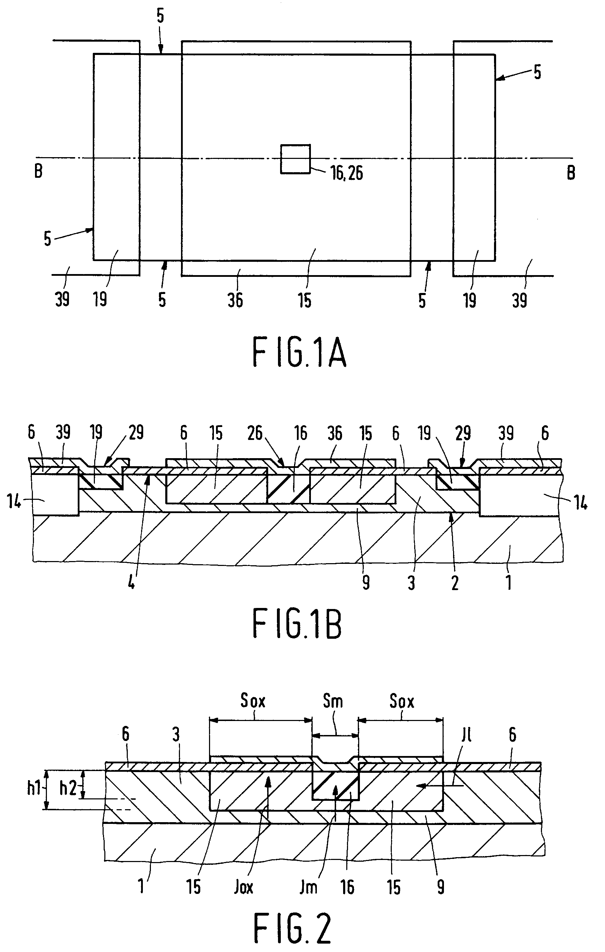

La FIG.1A montre vue du dessus, schématiquement, dans un exemple de réalisation, une partie d'un dispositif semiconducteur comprenant un transistor bipolaire vertical PNP conforme à l'invention. La FIG.1B montre une coupe selon B-B de cette partie du dispositif.

En référence avec les FIG. 1, dans cet exemple de réalisation, ce dispositif comporte un corps semiconducteur 1, ou substrat, par exemple en silicium (Si), d'un premier type de conductivité P, à la surface 2 duquel est appliquée une couche semiconductrice épitaxiale 3 du type de conductivité opposé N. Cette couche épitaxiale 3 est subdivisée en plusieurs parties, parmi lesquelles au moins un caisson 5, du deuxième type de conductivité N, au moyen de régions d'isolation 14, ces régions d'isolation 14 s'étendant sur toute l'épaisseur de la couche épitaxiale 3 depuis la surface supérieure 4 de cette couche jusqu'au substrat 1.

Le caisson 5 comporte un transistor bipolaire vertical PNP, ayant une région 15, 16, du premier type de conductivité P formée dans la couche épitaxiale 3 par exemple par implantation suivie de diffusion, de manière à laisser subsister entre la partie inférieure de la région 15, 16 du premier type P et le substrat 1 du premier type P, une région 9 de type N. La couche épitaxiale 3 est du type désigné par l'homme du métier comme mince ou ultramince. Des valeurs d'épaisseur seront données plus loin à titre d'exemple.

Les régions 15, 16 constituent la région d'émetteur, la région 9 constitue la base, et le substrat 1 constitue le collecteur du transistor vertical.

Une couche isolante 6, est réalisée pour protéger la surface principale 4 du dispositif semiconducteur.

La région d'émetteur est constituée de deux régions partielles d'émetteur. La première région partielle d'émetteur, dite région périphérique d'émetteur 15, a pour épaisseur une valeur h1. Une condition essentielle est appliquée à la valeur de l'épaisseur h1 et au niveau de conductivité, c'est-à-dire au niveau de dopage de cette première région partielle 15 : la valeur de l'épaisseur h1 et le niveau de conductivité doivent être tels que la longueur de diffusion des porteurs minoritaires, ici des électrons, injectés dans cette région partielle d'émetteur est supérieure à ladite épaisseur h1. Cela revient à dire que ladite première région partielle 15 doit être transparente pour les porteurs minoritaires injectés. Ceci est obtenu d'une part au moyen d'une épaisseur h1 faible correspondant à une région d'émetteur du genre couche mince à ce jour de plus en plus utilisée par l'homme du métier dans les nouvelles technologies de circuits intégrés. Ceci est obtenu d'autre part avec une telle première région partielle d'émetteur en outre moyennement dopée, c'est-à-dire du premier type de conductivité avec un premier niveau moyen, habituellement noté par l'homme du métier P ou $P^+$. Les niveaux de dopage seront précisés plus loins dans un procédé de réalisation donné à titre d'exemple.

La région d'émetteur comprend en outre une deuxième région partielle 16 d'émetteur, dite région centrale d'émetteur, d'aire moins grande et d'épaisseur h2 qui peut aller d'une valeur moitié de, à une valeur légèrement supérieure à celle de la première région partielle d'émetteur 15, qui s'étend depuis la surface 4 de la couche épitaxiale implantée, vers la partie inférieure de la première région partielle 15 d'émetteur. D'une façon générale, cette seconde région partielle d'émetteur 16 s'étend sur une épaisseur h2 peu différente de l'épaisseur h1 de la première région d'émetteur du fait que les couches sont ultraminces en général. De plus cette seconde région partielle d'émetteur est du premier type de conductivité, avec un second niveau de ce type de conductivité plus élevé que le premier niveau de la première région partielle. Un tel niveau élevé du second type de conductivité est noté $P^{++}$ par l'homme du métier, et est obtenu par un taux de dopage de la seconde région au moins double de celui de la première région. L'épaisseur h2 de la seconde région et son taux de dopage sont choisis pour que cette seconde région partielle d'émetteur 16 constitue un écran pour les porteurs minoritaires.

Dans le caisson 5, est aménagée une région de collecteur du premier type de conductivité implantée dans la couche épitaxiale entre la surface de cette couche et le substrat et fortement dopée $P^+$ pour diminuer la résistance de collecteur. Cette région de collecteur est munie d'un plot de contact de collecteur à sa surface, réalisé dans une ouverture pratiquée dans la couche isolante 6. Ce type de réalisation de région de collecteur est bien connu de l'homme du métier, et n'est donc pas représenté sur les dessins, pour des raisons de simplicité. En alternative à cette réalisation du contact de collecteur sur la face avant ou principale du circuit constituée par la face 4 de la couche épitaxiale, l'homme du métier peut réaliser le contact collecteur sur la face arrière du substrat.

La région de base 9 est disposée sous les régions d'émetteur 15, 16, entre ces régions d'émetteur et le substrat 1, formant un empilement vertical collecteur-base-émetteur. Cette région de base 9 est du second type de conductivité et d'un niveau de dopage moyen N suffisant pour éviter les inconvénients inhérents au dispositif connu de l'état de la technique (LEC Transistor).

La région de base 9 déborde la région d'émetteur 15 latéralement. Dans le prolongement latéral de cette région de base 9, est amenagée une région de base 19 qui affleure la surface 4 de la couche épitaxiale 3. Cette région de base 19 est du second type de conductivité, à un second niveau élevé $N^{++}$ de dopage pour diminuer la résistance de base. Une ouverture délimitant la zone de contact de base 29 est pratiquée en surface de la région 19, dans la couche isolante 6. Un plot de contact de base 39 est réalisé partiellement sur cette couche isolante 6 et dans la zone de contact de base 29.

L'association des deux régions partielles d'émetteur 15, 16 avec les caractéristiques décrites plus haut est essentielle pour arriver aux buts de l'invention.

Une ouverture délimitant la zone de contact d'émetteur 26 est pratiquée en surface de la région d'émetteur dans la couche isolante 6. Un plot de contact d'émetteur 36 est réalisé partiellement sur cette couche isolante 6 et dans la zone de contact 26.

Selon l'invention, la zone de contact électrique d'émetteur 26 a une aire faible devant l'aire de la première région partielle d'émetteur 15, et a sensiblement la même aire que la seconde région partielle centrale d'émetteur 16. Le rapport de l'aire de la première région partielle superficielle d'émetteur 15 sur l'aire de la zone de contact d'émetteur 26 est supérieure à 2. La zone de contact 26 est celle dans laquelle le plot de contact 36 est effectivement en contact avec la région d'émetteur.

Selon le second état de la technique cité, un tel plot de contact d'émetteur était réalisé de telle manière que la zone de contact occupait la majeure partie de l'aire des deux régions d'émetteur empilées, afin de minimiser la résistance d'émetteur. De plus, il était souhaité que l'aire totale des régions d'émetteur empilées soit faible.

Selon l'invention, on a mis en évidence que pour un transistor vertical dont l'émetteur est tel que la longueur de diffusion des porteurs minoritaires injectés verticalement dans celui-ci est supérieure ou égale à l'épaisseur de l'émetteur, les critères utilisés dans l'état de la technique relatifs à une aire de contact maximale sur une aire de région d'émetteur minimale, ne sont plus optimaux.

Une étude expérimentale appropriée à vérifier certaines hypothèses théoriques sur les propriétés de l'injection des porteurs dans l'émetteur a permis d'aboutir à un modèle d'injection simplifié, qui est explicité ci-après en référence avec la FIG. 2.

La FIG.2 montre schématiquement une région périphérique d'émetteur 15 de type P ou $P^+$ réalisée dans une couche 3 de type N formant la région de base. Une couche isolante de protection 6, est réalisée en surface de ce dispositif, et montre une ouverture 26 pour un plot de contact 36 d'émetteur. Le plot de contact 36 est réellement en contact avec la région d'émetteur 16 uniquement dans l'ouverture 26 d'aire Sm. L'aire de la couche 15 périphérique, constituée par l'aire totale de la région d'émetteur de laquelle on exclut l'aire 26 sous le contact d'émetteur, est par ailleurs notée Sox. L'aire de la seconde région partielle centrale 16 est sensiblement égale à l'aire de la zone de contact d'émetteur 26.

La première région partielle d'émetteur 15 a unedite première épaisseur h1 et undit premier niveau de dopage tel que la longueur de diffusion des porteurs minoritaires injectés verticalement dans celle-ci est supérieure ou égale à ladite première épaisseur h1. Dans cette couche de type P, les porteurs minoritaires sont les électrons qui se propagent vers la surface 4 de la couche d'émetteur. Les trous se propagent en sens inverse.

Si le transistor vertical est du type NPN au lieu d'être du type PNP comme dans l'exemple décrit, alors les porteurs minoritaires sont les trous au lieu d'être les électrons, mais le fonctionnement du transistor est soumis aux mêmes lois théoriques, en remplaçant simplement "électrons" par "trous" dans l'exposé.

On désigne par $J\ell$ la densité de courant d'injection latérale des porteurs minoritaires dans la base, par Jm la densité de courant d'injection verticale des porteurs minoritaires sous la zone de contact d'émetteur 16, et par Jox la densité de courant d'injection verticale des porteurs minoritaires sous la portion de couche isolante 6 qui recouvre la région périphérique d'émetteur 15. La densité latérale $J\ell$ est, dans un transistor vertical, supposée négligeable. Les densités de courant d'injection sont représentées par des flèches sur la FIG.2.

La théorie et l'expérience ont montré que l'expression du gain en courant $H_{FE}$ pouvait s'exprimer en première approximation par :

$$H_{FE} = K / (Jm.Sm + Jox.Sox)$$

où K est une constante pour un transistor vertical.

Selon l'invention, on augmente le gain en courant $H_{FE}$ en réduisant la grandeur Sm, en augmentant la grandeur Sox et en réduisant davantage le terme JmSm par la réduction du terme Jm de densité de courant.

Cet effet est obtenu lorsque :
- le rapport entre l'aire Sox de la région périphérique d'émetteur 15 et l'aire Sm de la zone de contact d'émetteur 26 est de l'ordre de ou supérieure à 2 ;
- une deuxième région partielle d'émetteur 16 existe et a une aire Sm sensiblement délimitée par la zone 26 de contact d'émetteur ;
- la deuxième région partielle 16 est une région qui présente undit deuxième niveau de conductivité, supérieur audit premier niveau de conductivité de la région partielle superficielle 15, noté $P^{++}$, avec une épaisseur h2 suffisante de telle manière que cette deuxième région 16 constitue un écran pour les porteurs minoritaires.

La nouvelle valeur de la densité de courant Jm sous le contact, dans la région 16, est plus petite d'un facteur environ 3, que la valeur de la densité de courant quand la région 16 n'est pas plus dopée que la région 15.

Le gain en courant est maintenant pratiquement uniquement la conséquence de l'injection verticale induite par l'injection sous la couche isolante, cette injection étant elle-même la conséquence de l'injection sous la zone de contact d'émetteur 26.

Sur la FIG.1A, l'aire relativement étendue de la première région 15 de l'émetteur en même temps qu'une zone de contact d'émetteur 26 ayant une aire limitée permet de mettre pleinement à profit ce phénomène d'injection sous la couche isolante, qui met en jeu des effets de surface des impuretés efficaces, et qui était perçu par l'état de la technique comme un phénomène globalement indésirable. Selon l'invention avec la réalisation de la région périphérique d'émetteur 15 moyennement dopée, et avec la réalisation de la région centrale d'émetteur 16 fortement dopée ayant une aire limitée à celle de la zone de contact 26, on a différencié le rôle des participations de ces régions et on a optimisé le fonctionnement du transistor vertical.

La théorie relative à l'augmentation du gain dans un transistor selon l'invention prend en compte les éléments techniques décrits ci-après dans l'exemple d'un transistor P-N-P. On doit tenir compte à la fois du taux de recombinaison des porteurs minoritaires et de leur longueur de diffusion.

Selon l'invention, pour augmenter le gain en courant du transistor, on prévilégie et en renforce les courants de trous par rapport aux courants d'électrons dans la direction verticale. Ce choix permet de minimiser le taux de recombinaison électrons-trous. Cette théorie est en accord avec la théorie de l'efficacité d'injection décrite dans la publication IEEE citée plus haut.

Par longueur de diffusion d'un porteur minoritaire, il faut entendre la distance moyenne parcourue par un porteur minoritaire dans un matériau donné, avant qu'il ne se recombine.

Par taux de recombinaison, il faut entendre le nombre de recombinaisons qui se produisent dans un volume donné par unité de temps. Le taux de recombinaison est une constante dont la valeur dépend de la géométrie du matériau, c'est-à-dire de son épaisseur et de son dopage.

Sous le contact métallique d'émetteur, dans le transistor latéral connu de l'état de la technique le taux de recombinaison est très élevée du fait que le matériau est quasiment métallique et le courant d'électrons est toujours très élevé. Selon l'invention, on choisit donc de réaliser une zone de contact d'émetteur d'aire très petite Sm pour minimiser le courant d'électrons ; et en même temps, on réalise une région partielle 16 très dopée.

Sous la couche isolante, le taux de recombinaison est faible. On choisit en outre le dopage et l'épaisseur de manière à ce que la longueur de diffusion soit supérieure à l'épaisseur h1 de la région périphérique d'émetteur. Ainsi, en adoptant une aire Sox, importante, on favorise le courant de trous dans cette région. Ce résulat est obtenu avec un dopage P relativement faible et une épaisseur h1 également faible. C'est une des raisons pour laquelle, la technologie mettant en oeuvre des transistors à couches minces est favorable à l'invention.

De la théorie reposant sur l'efficacité d'injection, il ressort que plus la couche centrale 16 est dopée par rapport à la couche périphérique 15 d'émetteur, plus le courant de trous est renforcé par rapport au courant d'électrons. Ce qui fait que la couche centrale très dopée 16 n'est pas un moyen supplémentaire pour minimiser la recombinaison électrons-trous, mais que cette couche centrale très dopée 16 vient coopérer avec la couche périphérique peu dopée 15 pour renforcer le courant de trous par rapport au courant d'électrons.

En effet, lorsque l'on augmente la différence de taux de dopage entre les régions 15 et 16, on crée entre les deux régions 15 et 16 un profil d'impuretés abruptes. Dans la pente du profil de dopage, il se crée un champ qui est répulsif pour les porteurs minoritaires, ici les électrons, et ainsi on favorise les trous.

Du fait de l'existence de la région centrale 16 très dopée, il est également favorable que les couches soient minces, c'est-à-dire que la distance entre le bas de la région 16 très dopée (voir la FIG.2) et le substrat soit très petite. Cependant, dans le cas actuel de couches ultraminces, vu les dimensions en jeu, la possibilité de réaliser des couches 15 et 16 avec des épaisseurs différentes est subordonnée aux moyens technologiques disponibles, et en fait il n'est pas rédhibitoire que lesdites couches 15 et 16 aient la même épaisseur h1 = h2 pour obtenir l'amélioration de gain escomptée. En effet avec ce type de structure à couches ultraminces, le gain augmente lorque le rapport des concentrations entre la totalité de charges P et la totalité de charges N augmente. Et ce rapport augmente d'autant plus que l'on garde une épaisseur d'émetteur h1, h2 à peu près constante, tout en diminuant l'épaisseur de la couche épitaxiale, ce qui diminue l'épaisseur de la région N et donc le nombre total de charges N. Donc selon l'invention, l'utilisation de structures à couches ultraminces est un avantage et non un inconvénient pour le gain. Cependant, si h2 devait devenir supérieur à h1, alors la capacité émetteur-base augmenterait.

En pratique, le gain en courant est limité par la résistance d'émetteur qui, dans le cas de la FIG.1A, est induite par les dimensions de la zone de contact 26 d'émetteur.

Il faut donc choisir les dimensions de la zone de contact d'émetteur 26 de manière à concilier un gain élevé avec une résistance d'émetteur acceptable.

Pour obtenir un transistor vertical ayant un courant élevé, on peut réaliser une structure de forme carrée comme sur la FIG.1A. Dans cette structure, la région 19 de base et la région de collecteur non représentée peuvent former par exemple des anneaux concentriques qui sont reliés chacun à un contact respectivement de base et de collecteur par les zones de contact correspondant à des ouvertures dans la couche isolante protectrice 6.

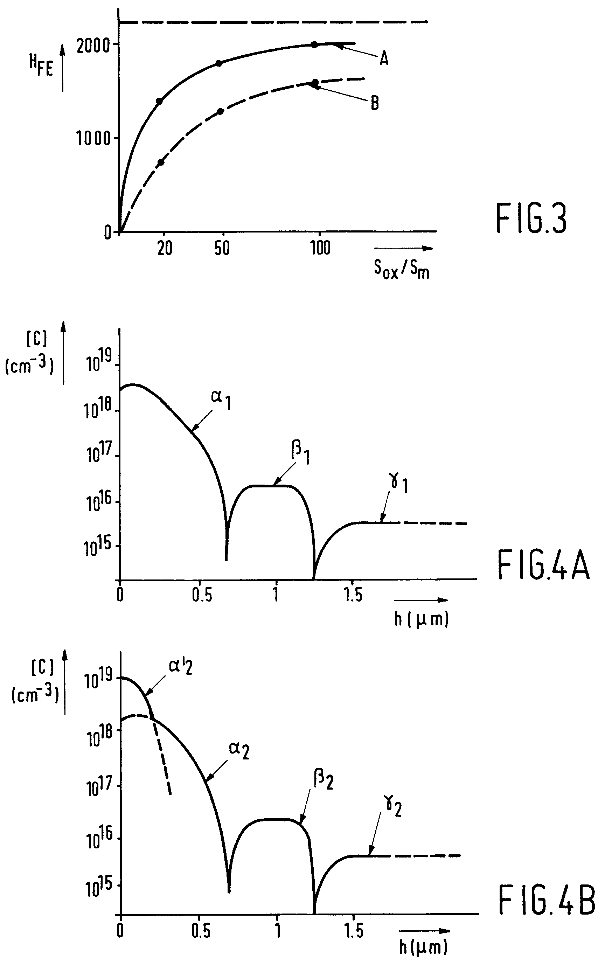

La FIG.3 représente des courbes du gain en courant $H_{FE}$ respectivement en fonction du rapport Sox/Sm. Le gain $H_{FE}$ est défini comme le rapport du courant collecteur au courant de base IC/IB, les transistors ayant les caractéristiques préconisées dans le procédé de réalisation décrit plus loin à titre d'exemple. La courbe A en trait plein concerne un transistor vertical avec une région partielle centrale 16 d'émetteur fortement dopée $P^{++}$, différentiée d'une région périphérique d'émetteur 15 moins dopée. La courbe B en trait discontinu concerne un transistor dit "de comparaison" ayant cette région 16 non différentiée de la région périphérique 15, donc ayant ces deux régions 15 et 16 du même dopage moyen P ou $P^+$.

Le gain en A est plus élevé. En outre ce gain est d'autant plus élevé que le rapport Sox/Sm augmente.

Un transistor vertical ayant une structure selon l'invention voit son gain $H_{FE}$ tendre vers un maximum qui est de l'ordre de 2200.

Comme il ressort de l'étude comparative des courbes A et B de la FIG.3, le transistor selon l'invention permet d'obtenir, dans certaines conditions, le même gain que le transistor dit de comparaison. Mais ces conditions sont telles que le transistor selon l'invention nécessite, pour obtenir ce gain, une aire Sox beaucoup moins grande que le transistor de comparaison. Par exemple, pour un gain $H_{FE}$ égal à 1000, avec le transistor, selon l'invention, (Sox/Sm) = 5, alors qu'avec le transistor de comparaison, (Sox/Sm) = 30.

Ou bien encore, pour un même rapport, c'est-à-dire une même aire, le transistor selon l'invention a un gain beaucoup plus élevé. Par exemple pour un rapport (Sox/Sm) = 5, correspondant à un faible encombrement, le transistor selon l'invention a un gain $H_{FE}$ = 1000, alors que le transistor de comparaison atteint seulement 300.

Ainsi, dans le transistor selon l'invention, avec un rapport des aires (Sox/Sm) seulement égal à 2, on obtient déjà le gain de 300.

Ceci est obtenu en outre sans effet néfaste secondaire relatif à la tension de claquage.

Le transistor selon l'invention représente donc un progrès considérable par rapport à l'état de la technique.

Le transistor a été décrit du type vertical PNP, mais rien ne s'oppose à ce qu'il soit du type NPN, selon toute structure NPN généralement connue de l'homme du métier. Dans un tel transistor vertical NPN, les deux régions partielles d'émetteur sont de type N avec les niveaux de conductivité moyen pour la région périphérique et fort pour la région centrale comme indiqué précédemment. Le rapport des surfaces Sox/Sm est aussi le même.

On décrit ci-après, à titre d'exemple non limitatif, un procédé de réalisation du dispositif représenté sur les FIG.1A et 1B.

Dans une partie d'une surface 2 d'un substrat 1 en silicium de type P, d'épaisseur environ 120 $\mu$m, ayant un taux de dopage d'environ $5.10^{15}$ $cm^{-3}$ et une résistivité environ 3 $\Omega$.cm, est réalisée de façon usuelle une couche épitaxiale 3 de silicium de type N d'une épaisseur pouvant être inférieure à 1 $\mu$m, ou pouvant aller jusqu'à 2 $\mu$m, ayant un taux de dopage d'environ $2.10^{16}$ $cm^{-3}$ et une résistivité de l'ordre de 0,3 $\Omega$.cm. Une couche épitaxiale ayant une épaisseur dans la fourchette indiquée est considérée comme mince ou ultramince par l'homme du métier. La couche épitaxiale 3 forme la région de base. Dans le transistor dont les courbes de gain sont données FIG.3, la couche épitaxiale avait une épaisseur de 1,25 $\mu$m.

La couche épitaxiale 3 peut être obtenue de type N par dopage à l'arsenic (As).

Les zones séparatrices 14 peuvent être réalisées au moyen de caissons d'isolement en oxyde de silicium $SiO_2$ (oxyde profond).

La région partielle périphérique 15 d'émetteur peut être réalisée au centre de la région de base, par l'implantation puis diffusion d'une impureté telle que le bore (B) permettant d'obtenir la conductivité P, au moyen d'un masque ayant une ouverture de grande surface. Dans l'exemple décrit, le taux de dopage maximal est de l'ordre de $5.10^{18}.cm^{-3}$, l'épaisseur h1 de l'ordre de 0,7 $\mu$m, et la résistance par carré de l'ordre de 500 $\Omega$. Avec ces valeurs, la première région partielle d'émetteur est transparente pour les porteurs minoritaires.

La seconde région partielle centrale 16 d'émetteur peut alors être réalisée par implantation puis diffusion d'une impureté telle que le bore (B) permettant d'obtenir la conductivité $P^{++}$ au moyen d'un masque d'ouverture réduite, avec un taux de dopage supérieur à celui de la première diffusion, le taux de dopage maximal dans cet exemple étant $2.10^{19}.cm^{-3}$ ; et sur une épaisseur h2 qui, dans cet exemple, est inférieure à l'épaisseur h1 de la région périphérique. Par exemple h2 = 0,4 $\mu$m. Mais, dans d'autres exemples, on peut réaliser h2 jusqu'à 0,8 $\mu$m, toutes les autres épaisseurs étant inchangées. La résistance par carré est, dans cet exemple, de l'ordre de 120 $\Omega$. Avec ces valeurs la seconde région patielle d'émetteur 16 est un écran pour les porteurs minoritaires.

D'une manière générale l'épaisseur h2 de la région centrale d'émetteur reste dans une fourchette entre la moitié de h1, à très légèrement supérieure à h1. La profondeur de l'implantation de la région d'émetteur est contrôlée pour conserver l'épaisseur voulue de région 9 de base entre émetteur et collecteur. Vu l'épaisseur choisie pour la couche épitaxiale 3, les épaisseurs h1 et h2 sont également considérées comme minces ou ultraminces.

Le rapport entre le dopage de la région centrale d'émetteur et le dopage de la région périphérique reste dans une fourchette 2 à 10, le dopage de la région périphérique 15 étant lié à l'épaisseur h1 pour que la longueur de diffusion des porteurs minoritaires soit supérieure à h1, et celui de la région centrale étant choisi pour former l'écran souhaité auxdits porteurs minoritaires en coopération avec l'épaisseur h2.

Une couche de protection 6, par exemple en silice ($SiO_2$) ou en nitrure de silicium ($Si3N_4$), est réalisée en surface de l'ensemble du dispositif, avec des ouvertures en surface des zones prévues pour les contacts.

Les FIG.4A et 4B montrent les profils de dopage des différentes régions en partant de la surface 4 du transistor latéral en allant vers le substrat 1, qui sont conformes au procédé de réalisation qui vient d'être décrit.

La FIG.4A représente le taux de dopage C en nombre d'impuretés par cm³ en ordonnée, en fonction de la profondeur h en $\mu$m en abscisse en coupe verticale à travers la région périphérique 16 de l'émetteur sous oxyde (couche isolante 6).

La partie $\alpha$1 correspond au taux de dopage de type P$^{++}$ ($10^{19}$ cm$^{-3}$) dans la région périphérique d'émetteur 16 sous oxyde sur une épaisseur de 0,7 $\mu$m, la partie $\beta$1 correspond au taux de dopage N ($2.10^{16}$ cm$^{-3}$) de base sous l'émetteur dans la couche épitaxiale 3 située entre 0,7 et 1,25 $\mu$m, et la partie $\gamma$1 correspond au taux de dopage du substrat 1 de type P ($5.10^{15}$. cm$^{-3}$).

La FIG.4B représente le taux de dopage C en nombre d'impuretés par cm³ en ordonnée, en fonction de la profondeur h en $\mu$m en abscisse en coupe verticale à travers la région centrale 16 d'émetteur sous métal (zone de contact 26).

La partie $\alpha$'2 correspond au dopage de type P$^{++}$ ($10^{19}$.cm$^{-3}$) dans la région d'émetteur 16, directement sous le métal 36, sur une épaisseur de 0,4 $\mu$m : la partie $\alpha$'2 correspond au taux de dopage de type P$^{+}$ sous la partie d'émetteur 16 entre 0,4 et 0,7 $\mu$m, la partie $\beta$2 correspond au dopage de type N ($2.10^{16}$ cm$^{-3}$) de base sous l'émetteur dans la couche épitaxiale 3 entre 0,7 et 1,25 $\mu$m ; et la partie $\gamma$2 correspond au dopage du substrat 1 de type P ($5.10^{15}$.cm$^{-3}$).

Ces courbes ont été tracées pour une épaisseur de couche épitaxiale 3 de 1,25 $\mu$m.

**Revendications**

1. Dispositif semiconducteur comprenant un transistor vertical, lequel présente :
   - une région de collecteur (1) et une région d'émetteur (15,16), chacune d'un premier type de conductivité, la région d'émetteur affleurant à une surface principale (4) du dispositif semiconducteur ;
   - une région intermédiaire de base (9) d'un second type de conductivité ;
   - au moins unedite zone de contact électrique d'émetteur (26) pour un plot métallique (36) de contact électrique d'émetteur, délimitée par une ouverture pratiquée en surface de la région d'émetteur dans une couche isolante (6) disposée sur ladite surface principale, et transistor dans lequel le rapport entre l'aire (Sox) de la région d'émetteur sous la couche isolante (6), dite première région partielle d'émetteur (15), et l'aire (Sm) de la région d'émetteur sous ladite zone de contact électrique d'émetteur (26), dite seconde région partielle d'émetteur (16), est au moins égal à 2, caractérisé en ce que :
   - les régions d'émetteur (15,16) et de base (9) sont du type dit mince ou ultramince,
   - la première région partielle d'émetteur (15) a unedite première épaisseur (h1) et undit premier niveau du premier type de conductivité obtenu par un premier taux de dopage, tels que la longueur de diffusion des porteurs minoritaires injectés verticalement dans cette première région partielle est supérieure ou égale à son épaisseur,
   - la seconde région partielle d'émetteur (16) a une seconde épaisseur h2 de valeur supérieure à la moitié de ladite première épaisseur h1, et undit second niveau du premier type de conductivité plus élevé que le premier, ce second niveau étant obtenu par un second taux de dopage plus élevé que le premier taux de dopage, cette seconde épaisseur et ce second taux étant choisis tels que cette seconde région partielle constitue un écran pour les porteurs minoritaires.

2. Dispositif selon la revendication 1, caractérisé en ce que l'épaisseur h2 de la seconde région partielle d'émetteur (16) est au plus égale à l'épaisseur h1 de la première région partielle d'émetteur (15).

3. Dispositif selon l'une des revendications 1 ou 2, caractérisé en ce que le rapport entre l'aire (Sox) de la première région partielle d'émetteur (15) et l'aire (Sm) de la seconde région partielle d'émetteur (16) est compris entre 2 et 100.

4. Dispositif selon la revendication 3, caractérisé en ce que le rapport entre l'aire (Sox) de la première région partielle d'émetteur (15) et l'aire (Sm) de la seconde région partielle d'émetteur (16) est compris entre 2 et 10.

5. Dispositif selon l'une des revendications 1 à 4, caractérisé en ce que l'aire (Sm) de la seconde région partielle d'émetteur et l'aire de la' zone de contact (26) qui sont sensiblement égales, sont aussi peu étendues que la technologie de réalisation le permet.

6. Dispositif selon l'une des revendications 1 à 5, caractérisé en ce que le rapport entre le taux de dopage de la seocnde région partielle d'émetteur (16) et le taux de dopage de la première région partielle d'émetteur (15) est au moins égal à 2.

FIG.1A

FIG.1B

FIG.2

FIG.3

FIG.4A

FIG.4B

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| A | WO-A-90 07193 (N.V. PHILIPS GLOEILAMPENFABRIEKEN) * abstract; figure 1B * | 1 | H01L29/08 |
| D,A | & EP-A-0 401 354 (PHILIPS) --- | | |
| A | EP-A-0 166 923 (INTERNATIONAL BUSINESS MACHINES CORPORATION) * abstract; figure 13 * --- | 1 | |
| A | EP-A-0 462 029 (SGS-THOMSON MICROELECTRONICS S.A.) * abstract; figure 3B * ----- | 1 | |
| | | | TECHNICAL FIELDS SEARCHED (Int.Cl.5) |
| | | | H01L |

The present search report has been drawn up for all claims

| Place of search | Date of completion of the search | Examiner |
|---|---|---|
| THE HAGUE | 4 July 1994 | Baillet, B |

EPO FORM 1503 03.82 (P04C01)